# EUROPÄISCHE PATENTANMELDUNG

(11) **EP 0 652 585 A1**
(43) Veröffentlichungstag der Anmeldung: **10.05.1995**
(21) Anmeldenummer: 94105261.5
(22) Anmeldetag: 05.04.1994
(51) Int. Cl.: H01J 37/32, H01L 31/18

(54) **Verfahren und Vorrichtung zum Ätzen von dünnen Schichten, vorzugsweise von Indium-Zinn-Oxid-Schichten**

(30) Priorität: 02.11.1993 DE 4337309
(71) Anmelder: LEYBOLD AKTIENGESELLSCHAFT, D-63450 Hanau (DE)
(72) Erfinder: Kretschmer, Karl-Heinz, Dr. Dr.-Ing., D-63110 Rodgau (DE); Lorenz, Gerhard, D-63755 Alzenau (DE); Gegenwart, Rainer, Dr. Dipl.-Phys., D-63222 Rödermark (DE)

(57) **Zusammenfassung**

Bei einer Vorrichtung zum Ätzen von dünnen Schichten, vorzugsweise Indium-Zinn-Oxid-Schichten auf Glassubstraten in einer Vakuumkammer (2), mit einer über dieser angeordneten Plasmaquelle (12), einem dieser gegenüberliegenden Substratträger (5) und mit einer mit dem Substratträger (5) verbundenen Hochfrequenzquelle (8), ist als Ätzgas Cl₂ oder Cl₂ und H₂ oder CH₄ in die Vakuumkammer (2) einlaßbar, wobei die Hochfrequenz-bias-Versorgung (8, 9) des Substratträgers (5) unabhängig von der Ätzteilchendichte einstellbar ist und wobei die Plasmaquelle (12) von einer separaten Hochfrequenzquelle (16) gespeist wird, die ein eigenes Anpassungsnetzwerk (17) aufweist.

## Beschreibung

Die Erfindung betrifft ein Verfahren und eine Vorrichtung zum Ätzen von dünnen Schichten, vorzugsweise von Indium-Zinn-Oxid-Schichten auf Glassubstraten in einer Vakuumkammer, mit einer in dieser angeordneten Plasmaquelle und einem dieser gegenüberliegenden Substratträger und mit einer mit dem Substratträger verbundenen Hochfrequenzquelle.

Das Ätzen von Indium-Zinn-Oxid-Schichten, sogenannten ITO-Schichten, wird überwiegend in naßchemischen Bädern ausgeführt. Der Nachteil bei diesen Verfahren liegt im umwelttechnischen Bereich in der Entsorgung der anfallenden flüssigen Chemikalien, sowie im isotropen Ätzverhalten und in der Partikelkontamination aufgrund von sich in den Bädern befindlichen Ätzrückständen. Hier bieten Trockenätzverfahren Vorteile, da die Ätzung durch reaktive Gase im Vakuum erfolgt und die Ätzung durch Beschleunigung von ionisierten Gasteilchen in Richtung des Substrates erfolgt. Die Ionisierung des Gases kann dabei durch ein Plasma geschehen.

Hinlänglich bekannt sind zum Trockenätzen von ITO Parallelplattenreaktor-Verfahren, die alle den Nachteil aufweisen, daß die Ätzteilchendichte und -arten nicht unabhängig von deren kinetischer Energie eingestellt werden können.

Ein anderes Problem beim ITO-Ätzen ist die unterschiedliche chemische Reaktivität der Bestandteile des ITO, nämlich Indium, Zinn und deren Oxidverbindungen. In Parallelplattenreaktor-Verfahren (RIE-Verfahren) muß daher das Reaktionsgleichgewicht eher zur physikalischen Reaktion verlagert werden (Sputterätzen), indem die Ionen durch hohe Bias-Spannungen (∼ 500 V) auf die Substrate beschleunigt werden. Dieser Beschuß führt jedoch auch zu einer starken Ätzung des Substratmaterials und damit zu einer geringen Selektivität. Aus diesem Grunde werden hier auch kohlenstoffhaltige oder Freone als Ätzgase eingesetzt, die ein gleichmäßiges Ätzen ermöglichen sollen. Diese Wirkung wird durch eine Kombination aus Ätzung und Passivierung erzielt, die allerdings dann zu niedrigen Ätzraten führt. Zudem ergibt sich nur ein sehr kleines Prozeßfenster, da immer an der scharfen Grenze zwischen Ätzen und Passivieren gearbeitet wird. Die kohlenstoffhaltigen Freone sind zudem als umweltbelastend eingestuft und die Fluoranteile ätzen zudem das Substratmaterial Glas bzw. Si0₂.

Der vorliegenden Erfindung liegt die Aufgabe zugrunde, ein für ITO geeignetes Ätzverfahren, sowie die geeignete Vorrichtung zu schaffen, die einerseits hohe Ätzraten ermöglicht und andererseits frei von den erwähnten Nachteilen ist.

Diese Aufgabe wird erfindungsgemäß dadurch gelöst, daß als Ätzgas Cl₂ oder Cl₂ und H₂ oder CH₄ in die Vakuumkammer einlaßbar und ein Prozeßgasdruck von 0,1 bis 10 µbar einstellbar ist, wobei die Hochfrequenz-bias-Versorgung des Substratträgers unabhängig von der Ätzteilchendichte einstellbar ist und wobei eine Plasmaquelle vorgesehen ist, die von einer separaten Hochfrequenzquelle gespeist wird und ein eigenes Anpassungsnetzwerk aufweist.

Die Erfindung sieht ein Ätzen mit Chlorgas vor, wobei bei einem entsprechenden Verhältnis von Ionen, Atomen, Molekülen und kinetischen Energien sowohl die Anforderungen an das rückstandsfreie Ätzen als auch eine hohe Selektivität zu Glas/Si0₂ ermöglicht wird. Die dazu notwendigen separaten Einstellungen von Plasmadichte und Teilchenenergie wird durch den Einsatz des plasmaquellengestützten Ätzverfahrens ermöglicht. Chlor ätzt sowohl Indium als auch Zinn. Durch Zusatz von Wasserstoff läßt sich zudem noch die Ätzung steuern, indem die Oxidverbindungen des Indiums und des Zinns reduziert werden.

Der Einsatz von leistungsfähigen Plasmaquellen ermöglicht Niederdruckprozesse (0,1 ... 10 µbar) mit Cl₂ oder Cl₂/H₂, wodurch eine partikelfreie Ätzung möglich ist, wie sie für Anwendungen in der Displaytechnik gefordert ist. Großflächige Ätzungen werden durch den Einsatz mehrerer Plasmaquellen und/oder der Aufweitung des Plasmas durch ein magnetisches Konfinement ermöglicht.

Der Einsatz von quellengestützten Verfahren ergibt Vorteile, da die Fragmentierung und Ionisation der Ätzgase in der Plasmaquelle erfolgt, die Energie der Teilchen jedoch unabhängig hiervon durch die HF-bias am Substratträger eingestellt werden kann. Dies ist für die beiden Ätzanforderungen gleichmäßiges Ätzen von ITO und selektives Ätzen zum unterliegenden Substratmaterial entscheidend.

Die Erfindung läßt die verschiedensten Ausführungsmöglichkeiten zu; eine davon ist in den anhängenden Zeichnungen näher dargestellt und zwar zeigen:
- Figur 1: einen Schnitt durch eine mit einer ITO-Schicht versehenes Glassubstrat und
- Figur 2: die rein schematische Darstellung der Ätzvorrichtung.

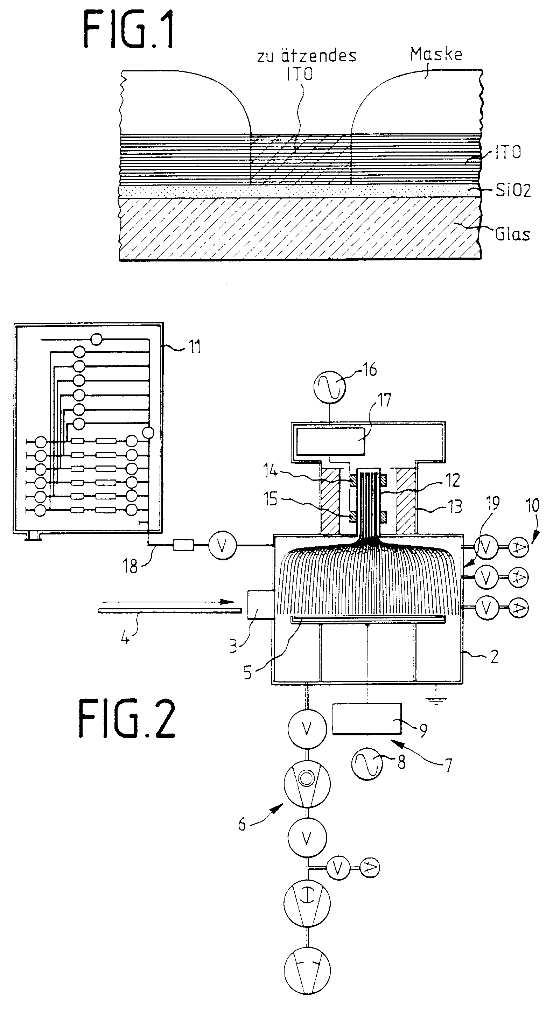

Die in Figur 2 gezeigte Vorrichtung besteht im wesentlichen aus der Vakuumkammer 2 mit der Schleuse 3 zum Ein- und Auschleusen des Substrats 4, der Substrathalterung 5, dem insgesamt mit 6 bezeichneten Vakuumpumpsatz, der mit der Substrathalterung 5 elektrisch verbundenen Energieversorgung 7 mit Hochfrequenzgenerator 8 und Anpassungsnetzwerk 9, dem Sichtfenster 10 in der Wand der Vakuumkammer 2 zur Beobachtung des Ätzprozesses, der Gasbox 11 mit den Dosierungseinrichtungen für das Prozeßgas Cl₂, H₂ oder CH₄, der Plasmaquelle 12, dem die Plasmaquelle 12 umschließenden Ringmagnet 13, den Antennen 14, 15 und der Hochfrequenzquelle 16 für die Plasmaquelle 12 mit dem Anpassungsnetzwerk 17.

Nach dem Einschleusen des Substrats 4 in die Vakuumkammer 2, dem Evakuieren der Kammer mit Hilfe des Pumpsatzes 6 und dem Einlassen von Prozeßgas aus der Gasbox 11 über die Gaszuführungsleitung 18 in die Vakuumkammer 2 werden sowohl die Antennen 14, 15 der Plasmaquelle 12 als auch die Substrathalterung 5, die die Ätzanode bildet, mit elektrischer Energie über die beiden Hochfrequenzquellen 8, 16 versorgt. Beide HF-Netzteile sind jeweils mit einem eigenen Anpassungsnetzwerk verbunden, so daß beispielsweise die Plasmaquelle separat einstellbar bzw. abstimmbar ist.

### Auflistung der Einzelteile

- 2: Vakuumkammer
- 3: Schleuse
- 4: Substrat
- 5: Substrathalterung, Ätzanode
- 6: Vakuumpumpensatz
- 7: Energieversorgung
- 8: Hochfrequenzgenerator
- 9: Anpassungsnetzwerk
- 10: Beobachtungsfenster
- 11: Gasbox
- 12: Plasmaquelle
- 13: Ringmagnet, das magnetische bucket (oder englisch confinement) ist Teil der Vakuumkammer, siehe Figur 2
- 14: Antenne
- 15: Antenne
- 16: Hochfrequenzquelle
- 17: Anpassungsnetzwerk
- 18: Gaszuführleitung
- 19: magnetisches bucket

## Patentansprüche

1. Vorrichtung zum Ätzen von dünnen Schichten, vorzugsweise Indium-Zinn-Oxid-Schichten auf Glassubstraten in einer Vakuumkammer (2), mit einer über dieser angeordneten Plasmaquelle (12) und einem dieser gegenüberliegenden Substratträger (5) und mit einer mit dem Substratträger (5) verbundenen Hochfrequenzquelle (8), **dadurch gekennzeichnet**, daß als Ätzgas Cl₂ oder Cl₂ und H₂ oder CH₄ in die Vakuumkammer (2) einlaßbar und ein Prozeßgasdruck von 0,1 bis 10 µbar einstellbar ist, wobei die Hochfrequenz-bias-Versorgung (8) des Substratträgers (5) unabhängig von der Ätzteilchendichte einstellbar ist und wobei die Plasmaquelle (12) von einer separaten Hochfrequenzquelle (16) gespeist wird, die ein eigenes Anpassungsnetzwerk (17) aufweist.

2. Vorrichtung nach Anspruch 1, **dadurch gekennzeichnet**, daß die Plasmaquelle (12) eine Hochfrequenzquelle, beispielsweise eine ECR-Quelle oder eine kapazitiv gekoppelte Hochfrequenzquelle, beispielsweise eine Helikonquelle ist.

3. Vorrichtung nach den Ansprüchen 1 und 2. **dadurch gekennzeichnet**, daß die Plasmagenerierung aus einer oder mehreren Plasmaquellen (12) und einem magnetischen bucket (19), das Teil der Vakuumkammer ist, zum Aufweiten des Plasmas erfolgt.

4. Verfahren zum Ätzen von dünnen Schichten, vorzugsweise Indium-Zinn-Oxid-Schichten auf Glassubstraten in einer Vakuumkammer (2), mit einer über dieser angeordneten Plasmaquelle (12) und einem dieser gegenüberliegenden Substratträger (5) und mit einer mit dem Substratträger (5) verbundenen Hochfrequenzquelle wird in einem ersten Verfahrensschritt als Ätzgas Cl₂ oder Cl₂ und H₂ oder CH₄ in die Vakuumkammer (2) eingelassen bis auf einen Prozeßgasdruck von 0,1 bis 10 µbar, in einem zweiten Verfahrensschritt wird die Hochfrequenz-bias-Versorgung (8) des Substratträgers (5) unabhängig von der Ätzteilchendichte eingestellt, wobei die Plasmaquelle (12) von einer separaten Hochfrequenzquelle (16) gespeist wird, die ein eigenes Anpassungsnetzwerk (17) aufweist.
